# FASCICULE DE BREVET EUROPEEN

(11) **EP 2 257 145 B1**
(45) Date de publication et mention de la délivrance du brevet: **29.02.2012**
(21) Numéro de dépôt: 10164388.0
(22) Date de dépôt: 28.05.2010
(51) Int. Cl.: H05K 7/14

(54) **Dispositif de connexion**
Verbindungsvorrichtung
Connection device

(30) Priorité: 28.05.2009 FR 0902575
(43) Date de publication de la demande: 01.12.2010
(73) Titulaire: CONNECTEURS ELECTRIQUES DEUTSCH, 27091 Evreux Cedex 9 (FR)
(72) Inventeur: Moreau, Jean-Luc, 28200, Chateaudun (FR)
(74) Mandataire: Laget, Jean-Loup

(56) Documents cités:
- WO-A-03/063560
- US-A1- 2005 174 734

## Description

### Domaine technique de l'invention

La présente invention se rapporté à un dispositif de connexion d'un équipement ou d'une carte électronique.

### Etat de la technique

Il existe des équipements ou cartes électroniques destinés à être connectés sur un connecteur de fond de rack, La connexion électrique est réalisée par exemple par des contacts broches d'un côté et des contacts femelles d'un autre. Lors de la mise en place de la carte électronique, il est nécessaire de déplacer la carte parallèlement aux contacts broches pour ne pas les abimer. Ensuite, il faut verrouiller la carte électronique sur le fond de rack, à l'aide d'un outil. De manière similaire, lors du retrait de la carte, il est nécessaire de la déplacer parallèlement aux contacts broches.

L'installation et la dépose d'une carte électronique sont donc des opérations minutieuses et fastidieuses.

### Résumé de l'invention

Un problème que la présente invention propose de résoudre est de fournir un dispositif de connexion qui ne présente pas au moins certains des inconvénients précités de l'art antérieur. En particulier, un but de l'invention est de proposer un dispositif de connexion qui peut être installé facilement et rapidement, sans risque d'abimer des contacts électriques et sans nécessiter d'outil. Un autre but de l'invention est de proposer un dispositif de connexion qui peut être désinstallé facilement et rapidement, sans risque d'abimer des contacts électriques et sans nécessiter d'outil.

La solution proposée par l'invention est un dispositif de connexion selon la revendication 1

Le document WO 03/063560 décrit un système d'insertion et d'extraction d'une carte de circuit imprimé comportant un accrochage mécanique en fond de rack par déplacement d'un cliquet, assuré au moyen d'un levier articulé sur la carte et commandé par une tige déplaçable depuis l'extérieur du rack, dans le sens d'insertion de la carte. Le levier est disposé sur la grande face de la carte et en augmente l'épaisseur.

Lorsque les organes d'accouplement sont dans leur position d'accouplement, les crochets peuvent être insérés dans des évidements du fond de rack. A ce stade, l'organe de connexion n'est pas en contact avec un organe correspondant du fond de rack. Ensuite, le mécanisme de commande est manipulé par l'installateur. Les crochets se rapprochent du support, mais sont maintenus dans les évidements du fond de rack. Ce faisant, les organes d'accouplement tirent donc le support et l'organe de connexion vers le fond de rack. Comme les déplacements des deux crochets par rapport au support sont coordonnés, le support se déplace dans une direction déterminée correspondant par exemple à la direction des contacts broches, si l'organe de connexion est de ce type. Ainsi, grâce à ces caractéristiques, le dispositif d'accouplement peut être installé facilement et rapidement. Le risque d'abimer l'organe de connexion est limité. De plus, aucun outil n'est nécessaire car une fois que les organes d'accouplement sont dans leur position d'accouplement, le dispositif de connexion est maintenu en place par les crochets. De plus, si le mécanisme de commande est également apte à déplacer conjointement les deux organes d'accouplement de leurs positions accouplées à leurs positions d'accouplement, le dispositif d'accouplement peut être retiré facilement et rapidement.

De préférence, ledit support présente une forme sensiblement rectangulaire, lesdits organes d'accouplement étant agencés le long de deux côtés opposés dudit support.

Avantageusement, ledit organe de connexion est agencé à mi-distance entre les deux organes d'accouplement.

Les caractéristiques précitées assurent une bonne répartition des efforts lors de l'installation.

Selon un mode de réalisation particulier, ladite portion élastiquement déformable et ledit crochet sont réalisés par une lame métallique pliée.

Dans ce cas, l'organe d'accouplement peut être réalisé facilement en pliant une lame métallique de manière appropriée.

Avantageusement, ledit mécanisme de commande comprend un organe de verrouillage apte à maintenir ledit mécanisme de commande dans un état correspondant à la position accouplée des deux organes d'accouplement.

Il s'agit de préférence d'un verrouillage automatique. Ainsi, quand l'installateur a manipulé le mécanisme de verrouillage pour faire passer les organes d'accouplement dans leur position accouplée, le dispositif de connexion est maintenu en place et verrouillé. Aucune manipulation supplémentaire n'est nécessaire.

De préférence, chacun des deux organes d'accouplement présente une face apte à coopérer avec ledit support de manière à déplacer lesdits crochets l'un vers l'autre lorsque les deux organes d'accouplement passent de la position d'accouplement à la position accouplée.

Les crochets étant écartés l'un de l'autre dans la position d'accouplement, ils peuvent être insérés facilement dans des évidements du fond de rack présentant une ouverture latérale.

### Brève description des figures

L'invention sera mieux comprise, et d'autres buts, détails, caractéristiques et avantages de celle-ci apparaîtront plus clairement au cours de la description suivante d'un mode de réalisation particulier de l'invention, donné uniquement à titre illustratif et non limitatif, en référence aux dessins annexés. Sur ces dessins :
- la figure 1 est une vue en perspective d'un dispositif de connexion selon un mode de réalisation de l'invention, et d'un connecteur de fond de rack,
- la figure 2 est une vue en perspective du dispositif de connexion de la figure 1, les organes d'accouplement étant dans leur position d'accouplement,
- la figure 3 est une vue en perspective du dispositif de connexion de la figure 1, les organes d'accouplement étant dans leur position d'accouplement et les crochets étant insérés dans des évidements du connecteur de fond de rack, et
- la figure 4 est une vue en coupe du dispositif de connexion de la figure 1, les organes d'accouplement étant dans leur position accouplée et les crochets étant insérés dans des évidements du connecteur de fond de rack.

### Description détaillée d'un mode de réalisation de l'invention

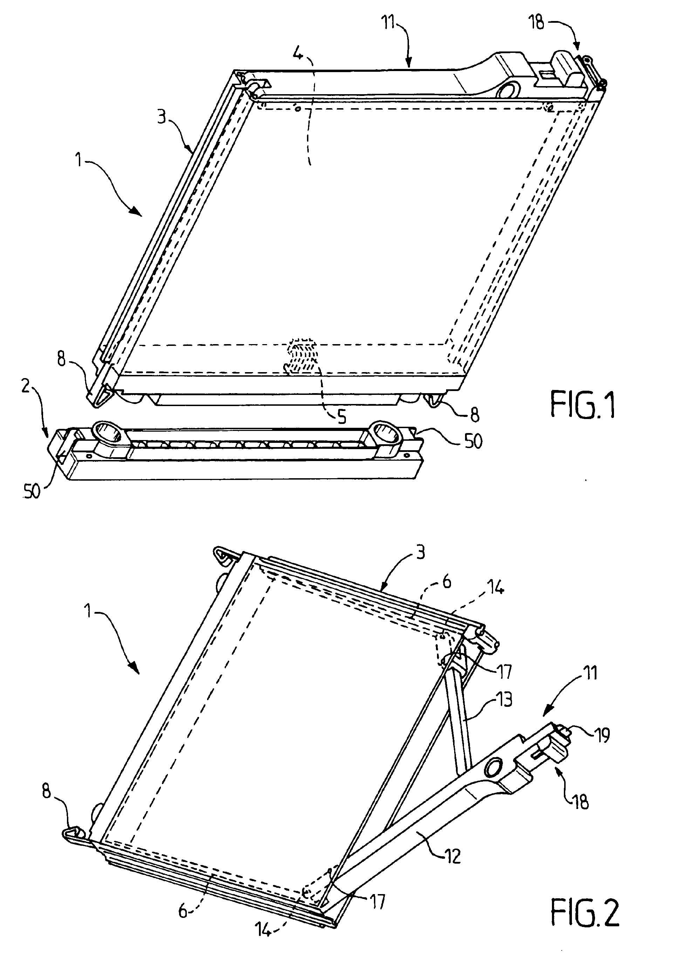

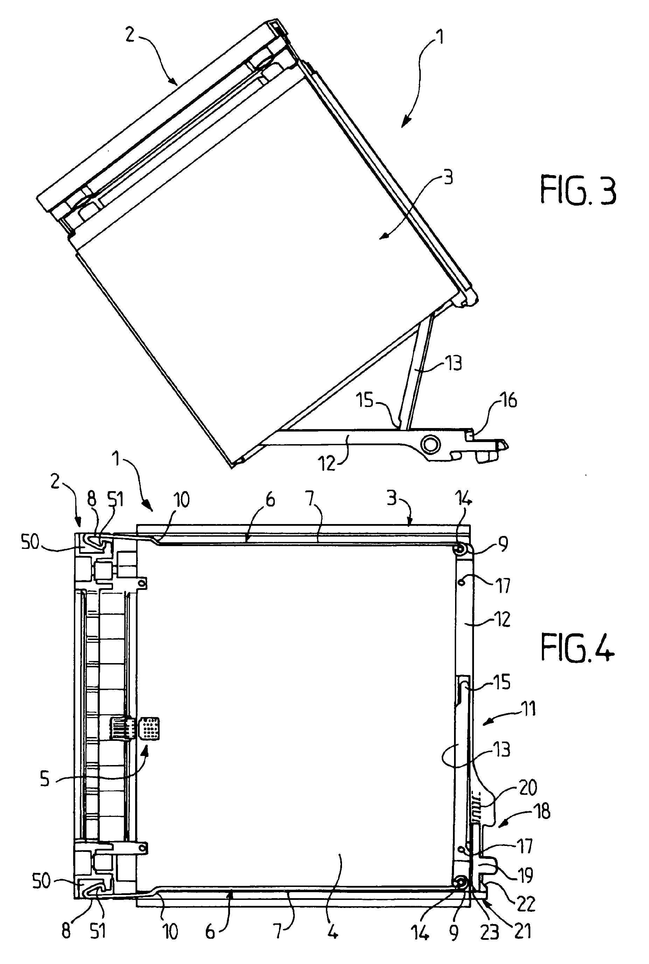

Les figures 1 à 4 représentent un dispositif de connexion 1 et un connecteur 2 de fond de rack. Le dispositif de connexion 1 est destiné à être relié au connecteur 2, comme représenté sur la figure 4.

Le dispositif de connexion 1 comprend un boîtier 3 et une carte 4 agencée dans le boîtier 3. La carte 4 porte un circuit électronique ou électrique (non représenté). Le dispositif de connexion 1 comprend aussi un organe de connexion 5, comprenant par exemple des contacts broches. Sur la figure 4, l'organe de connexion 5 est relié à un organe de connexion (non représenté) du connecteur 2, de manière à relier le circuit de la carte 4 à d'autres éléments électriques.

Comme on peut le voir sur les figures 1 et 4, le connecteur 2 et la face du dispositif de connexion 1 tournée vers le connecteur 2 présentent des configurations complémentaires, permettant l'assemblage représenté sur la figure 4. Le connecteur 2 comprend en outre deux évidements 50. Les évidements 50 sont ouverts latéralement et présentent une face 51 interne, du côté du dispositif de connexion 1.

Le dispositif de connexion 1 comprend également deux organes d'accouplement 6. Chaque organe d'accouplement 6 est constitué d'une lame métallique pliée de manière à former une portion longitudinale 7, un crochet 8 au niveau d'une extrémité de la portion longitudinale 7 et une extrémité 9 enroulée du côté opposé. La portion longitudinale 7 de la lame présente également une pente 10. Les organes d'accouplement 6 sont agencés principalement dans le boîtier 3, le long de deux côtés opposés de la carte 4. Les crochets 8 font saillie hors du boîtier 3.

Comme on peut le voir sur les figures, les organes d'accouplement 6 peuvent se déplacer par rapport au boîtier 3, entre une position d'accouplement représentée sur les figures 2 et 3 et une position accouplée représentée sur les figures 1 et 4. Un mécanisme de commande 11 permet de faire passer les organes d'accouplement 6 de leur position d'accouplement à leur position accouplée, et inversement.

Le mécanisme de commande 11 comprend un levier 12 et une bielle 13. Le levier 12 et la bielle 13 peuvent pivoter par rapport au boîtier 3, respectivement autour d'axes 17.

L'extrémité 15 de la bielle 13 est reliée au levier 12 par un axe (non représenté) qui peut coulisser dans une rainure 16 ménagée dans le levier 12. L'extrémité opposée de la bielle porte un pion 14. Un des organes d'accouplement 6 est relié à cette extrémité de la bielle 13, avec l'extrémité 9 enroulée autour du pion 14.

Une extrémité du levier 12 comprend également un pion 14. L'extrémité 9 de l'autre organe d'accouplement 6 est enroulée autour du pion 14.

Le mécanisme de commande 11 comprend également un organe de verrouillage 18. L'organe de verrouillage 18 comprend un doigt de verrouillage 19 agencé sur le levier 12. Le doigt de verrouillage 19 est sollicité par un ressort 20 et présente une face 23 inclinée. L'organe de verrouillage 18 comprend également un réceptacle 21, destiné à recevoir l'extrémité du doigt de verrouillage 19 comme le montre la figure 4. Le réceptacle 21 présente une face 22 inclinée.

Le fonctionnement du dispositif de connexion 1 est le suivant.

La figure 2 représente le dispositif de connexion 1 prêt à être installé. Le levier 12 est relevé. Les organes d'accouplement 6 sont dans leur position d'accouplement. Dans cette position, les crochets 8 sont situés à distance du boîtier 3, et éloignés l'un de l'autre.

Cela permet de rapprocher le dispositif de connexion 1 du connecteur 2 de manière à insérer les crochets 8 dans les évidements 50, comme le montre la figure 3. Sur la figure 3, les crochets 8 sont dans les évidements 50, mais le boitier 3 est à distance du connecteur 2 de fond de rack.

L'installateur peut alors baisser le levier 12. En pivotant, le levier 12 fait également pivoter la bielle 13. Les pions 14 du levier 12 et de la bielle 13 tirent sur les organes d'accouplement 6. Ainsi, les crochets 8 se rapprochent du boîtier 3. Lors de ce déplacement relatif, comme le montre la figure 4, les crochets 8 sont en appui contre les faces 51 des évidements 50. Ainsi, le boitier 3 se rapproche du connecteur 2. Au cours de ce mouvement, les faces des organes d'accouplement 6, au niveau des pentes 10, coopèrent avec le boîtier 3 pour pousser les crochets 8 l'un vers l'autre. Ainsi, lorsque le levier est complètement baissé, comme sur la figure 4, les crochets 8 sont maintenus dans les évidements 50 et ne peuvent pas en sortir.

Parallèlement, le boitier 3 s'est rapproché du connecteur 2 et l'organe de connexion 5 est entré en contact avec l'organe de connexion correspondant du connecteur 2. Comme le mécanisme de commande 11 déplace les organes d'accouplement 6 de manière coordonnée, le déplacement du boitier 3 par rapport au connecteur 2 s'est fait dans une direction déterminée (horizontalement sur la vue de la figure 4). De plus, comme les organes d'accouplement 6 sont disposés de part et d'autre du boîtier 3, avec l'organe de connexion 5 au milieu, les efforts sont bien répartis. Ainsi, on évite d'endommager l'organe de connexion 5. Par exemple, s'il s'agit de contacts broches, on évite de tordre les broches.

Juste avant d'arriver dans la position de la figure 4, la face 23 du doigt de verrouillage 19 coopère avec la face 22 du réceptacle 21 pour pousser le doigt de verrouillage 19 à l'encontre de la sollicitation du ressort 20. Ensuite, lorsque le levier 12 arrive dans la position de la figure 4, le ressort 20 pousse sur le doigt de verrouillage 19 et le fait rentrer dans le réceptacle 21. Le levier 12 est donc maintenu en position. Ainsi, les organes d'accouplement 6 ne peuvent plus se déplacer et le dispositif de connexion 1 est accouplé au connecteur 2 de manière verrouillée. Il faut remarquer que l'installateur a uniquement dû manipuler le levier 12. Le verrouillage s'est réalisé automatiquement et aucun outil n'a été nécessaire.

Dans l'état de la figure 4, la portion longitudinale 7 des lames formant les organes d'accouplement 6 est allongée élastiquement par rapport à l'état représenté sur les figures 1 à 3. Ainsi, la portion longitudinale 7 exerce un effort de traction maintenant le dispositif de connexion 1 contre le connecteur 2 de fond de rack.

Pour pouvoir retirer le dispositif de connexion 1, il suffit de déplacer le doigt de verrouillage 19 à l'encontre du ressort 20 puis de relever le levier 12. Le mécanisme de commande 11 va alors déplacer les organes d'accouplement 6 de leurs positions accouplées à leurs positions d'accouplement. Lors de ce déplacement, chaque crochet 8 prend appui respectivement sur une face des évidements 50 opposée à la face 51. Le déplacement relatif des organes d'accouplement 6 et du boîtier 3 a donc pour effet d'éloigner le boîtier 3 du connecteur 2. Ici aussi, grâce à la structure du dispositif de connexion 1, on évite d'endommager l'organe de connexion 5.

Bien que l'invention ait été décrite en liaison avec un mode de réalisation particulier, il est bien évident qu'elle n'y est nullement limitée et qu'elle comprend tous les équivalents techniques des moyens décrits ainsi que leurs combinaisons si celles-ci entrent dans le cadre de l'invention.

## Revendications

1. Dispositif de connexion destiné à être relié à un connecteur (2) de fond de rack, comprenant : un boîtier (3), une carte (4) portant un circuit électrique ou électronique et un organe de connexion (5) destiné à relier ledit circuit au connecteur (2), deux organes d'accouplement (6) comprenant chacun un crochet (8) et étant mobiles par rapport au boîtier (3) entre une position d'accouplement et une position accouplée, et un mécanisme de commande (11) apte à déplacer conjointement les deux organes d'accouplement (6) de leur position d'accouplement à leur position accouplée, **caractérisé en ce que** :
- chacun des organes d'accouplement (6) est constitué d'une lame métallique pliée comportant une position longitudinale (7) élastiquement déformable apte à s'allonger entre ledit crochet (8) et ledit mécanisme de commande (11),
- les organes d'accouplement (6) sont situés le long de deux côtés opposés de la carte (4),
- dans la position d'accouplement, les crochets (8) sont écartés l'un de l'autre et insérables dans des évidements (50) du connecteur (2),
- les crochets (8) sont plus proches du boîtier (3) dans la position accouplée que dans la position d'accouplement, et
- en passant de la position d'accouplement à la position accouplée, les crochets (8) se rapprochent l'un de l'autre et se rapprochent du boîtier (3) ce qui fait rapprocher le boîtier (3) du connecteur (2).

2. Dispositif de connexion selon la revendication 1, dans lequel ledit boîtier (3) présente une forme sensiblement rectangulaire, lesdits organes d'accouplement étant agencés le long de deux côtés opposés dudit boîtier (3).

3. Dispositif de connexion selon la revendication précédente, dans lequel ledit organe de connexion est agencé à mi-distance entre les deux organes d'accouplement.

4. Dispositif de connexion selon l'une des revendications précédentes, dans lequel ledit mécanisme de commande comprend un organe de verrouillage (18) apte à maintenir ledit mécanisme de commande dans un état correspondant à la position accouplée des deux organes d'accouplement.

5. Dispositif de connexion selon l'une des revendications précédentes, dans lequel chacun des deux organes d'accouplement présente une pente (10) apte à coopérer avec ledit boîtier (3) de manière à déplacer lesdits crochets l'un vers l'autre lorsque les deux organes d'accouplement passent de la position d'accouplement à la position accouplée.

## Claims

1. A connecting device intended to be connected to a rack bottom connector (2), comprising: a casing (3), a board (4) bearing an electrical or electronic circuit and a connecting member (5) intended to connect said circuit to the connector (2), two coupling members (6) each comprising a hook (8) and being mobile relative to the casing (3) between a coupling position and a coupled position, and a control mechanism (11) able to jointly move the two coupling members (6) from their coupling position to their coupled position, **characterized in that**:
- each of the coupling members (6) is made up of a folded metal strip comprising an elastically deformable longitudinal position (7) capable of stretching between said hook (8) and said control mechanism (11),
- the coupling members (6) are situated along two opposite sides of the board (4),
- in the coupling position, the hooks (8) are spaced apart from one another and can be inserted into recesses (50) of the connector (2),
- the hooks (8) are closer to the casing (3) in the coupled position than in the coupling position, and
- in going from the coupling position to the coupled position, the hooks (8) come closer to one another and come closer to the casing (3), which causes the casing (3) to come closer to the connector (2).

2. The connecting device according to claim 1, wherein said casing (3) has a substantially rectangular shape, said coupling members being arranged along two opposite sides of the casing (3).

3. The connecting device according to the preceding claim, wherein said connecting member is arranged midway between the two coupling members.

4. The connecting device according to one of the preceding claims, wherein said control mechanism comprises a locking member (18) capable of keeping said control mechanism in a state corresponding to the coupled position of the two coupling members.

5. The connecting device according to one of the preceding claims, wherein each of the two coupling members has a slope (10) able to cooperate with said casing (3) so as to move said hooks toward one another when the two coupling members go from the coupling position to the coupled position.

## Patentansprüche

1. Verbindungsvorrichtung, die dazu bestimmt ist, mit einem Verbinder (2) am Boden eines Racks verbunden zu sein, umfassend: ein Gehäuse (3), eine Karte (4) mit einem elektrischen oder elektronischen Schaltkreis und ein Verbindungsorgan (5), das dazu bestimmt ist, den Schaltkreis mit dem Verbinder (2) zu verbinden, zwei Kopplungsorgane (6), die jeweils einen Haken (8) umfassen und im Verhältnis zum Gehäuse (3) zwischen einer Kopplungsstellung und einer gekoppelten Stellung bewegbar sind, und einen Steuermechanismus (11), der imstande ist, die zwei Kopplungsorgane (6) gemeinsam von ihrer Kopplungsstellung in ihre gekoppelte Stellung zu verschieben, **dadurch gekennzeichnet, dass**:
- jedes der Kopplungsorgane (6) von einem gebogenen Metallstreifen gebildet wird, der eine elastisch verformbare Längsstellung (7) aufweist, die imstande ist, sich zwischen dem Haken (8) und dem Steuermechanismus (11) zu verlängern,
- sich die Kopplungsorgane (6) entlang von zwei gegenüberliegenden Seiten der Karte (4) befinden,
- die Haken (8) in der Kopplungsstellung voneinander entfernt sind und in Aussparungen (50) des Verbinders (2) einführbar sind, und
- sich die Haken (8) beim Übergang von der Kopplungsstellung in die gekoppelte Stellung einander annähern und sich dem Gehäuse (3) annähern, was bewirkt, dass sich das Gehäuse (3) dem Verbinder (2) annähert.

2. Verbindungsvorrichtung nach Anspruch 1, wobei das Gehäuse (3) eine etwa rechteckige Form aufweist, wobei die Kopplungsorgane entlang von zwei gegenüberliegenden Seiten des Gehäuses (3) ausgebildet sind.

3. Verbindungsvorrichtung nach vorangehendem Anspruch, wobei das Verbindungsorgan in halbem Abstand zwischen den zwei Kopplungsorganen ausgebildet ist.

4. Verbindungsvorrichtung nach einem der vorangehenden Ansprüche, wobei der Steuermechanismus ein Verriegelungsorgan (18) umfasst, das imstande ist, den Steuermechanismus in einem Zustand zu halten, der der gekoppelten Stellung der zwei Kopplungsorgane entspricht.

5. Verbindungsvorrichtung nach einem der vorangehenden Ansprüche, wobei jedes der zwei Kopplungsorgane eine Neigung (10) aufweist, die imstande ist, mit dem Gehäuse (3) derart zusammenzuarbeiten, dass die Haken zueinander verschoben werden, wenn die zwei Kopplungsorgane von der Kopplungsstellung in die gekoppelte Stellung wechseln.
